(19) Europäisches Patentamt
European Patent Office
Office européen des brevets

(11) **EP 3 830 789 B1**

(12) **FASCICULE DE BREVET EUROPEEN**

(45) Date de publication et mention de la délivrance du brevet:
**08.06.2022 Bulletin 2022/23**

(21) Numéro de dépôt: **19744733.7**

(22) Date de dépôt: **30.07.2019**

(51) Classification Internationale des Brevets (IPC):
**G06T 7/00** *(2017.01)* **G06T 7/33** *(2017.01)*
**G01N 21/64** *(2006.01)* **G01N 21/95** *(2006.01)*
**H01L 21/66** *(2006.01)* **G01N 21/956** *(2006.01)*

(52) Classification Coopérative des Brevets (CPC):
**G01N 21/6489; G01N 21/9501; G06T 7/001; G06T 7/337;** G01N 21/95607; G06T 2207/20021; G06T 2207/20212; G06T 2207/30148; H01L 22/12

(86) Numéro de dépôt international:
**PCT/EP2019/070522**

(87) Numéro de publication internationale:
**WO 2020/025625 (06.02.2020 Gazette 2020/06)**

(54) **ANALYSE D'AU MOINS UN TYPE DE DEFAUTS PARMI UNE PLURALITE DE TYPES DE DEFAUTS ENTRE AU MOINS DEUX ECHANTILLONS**

ANALYSE VON DEFEKTEN VON MINDESTENS EINEM TYP UNTER EINER VIELZAHL VON TYPEN VON DEFEKTEN ZWISCHEN MINDESTENS ZWEI PROBEN

ANALYSIS OF DEFECTS OF AT LEAST ONE TYPE FROM AMONG A PLURALITY OF TYPES OF DEFECTS BETWEEN AT LEAST TWO SAMPLES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.07.2018 FR 1857140**

(43) Date de publication de la demande:
**09.06.2021 Bulletin 2021/23**

(73) Titulaire: **Commissariat à l'Energie Atomique et aux Energies Alternatives
75015 Paris (FR)**

(72) Inventeurs:
• **DAHAN, Patrick-Jeremy**
**38054 GRENOBLE CEDEX 09 (FR)**
• **FAVRE, Wilfried**
**38054 GRENOBLE CEDEX 09 (FR)**
• **VARACHE, Renaud**
**38054 GRENOBLE CEDEX 09 (FR)**

(74) Mandataire: **Cabinet Camus Lebkiri
25 rue de Maubeuge
75009 Paris (FR)**

(56) Documents cités:
**US-A1- 2016 313 256 US-A1- 2016 322 934**

• **NOS O ET AL: "Quality control method based on photoluminescence imaging for the performance prediction of c-Si/a-Si:H heterojunction solar cells in industrial production lines", SOLAR ENERGY MATERIALS AND SOLAR CELLS, vol. 144, 2016, pages 210-220, XP029304977, ISSN: 0927-0248, DOI: 10.1016/J.SOLMAT.2015.09.009**
• **LISA GOTTESFELD BROWN: "A survey of image registration techniques", ACM COMPUTING SURVEYS, ACM, NEW YORK, NY, US, US, vol. 24, no. 4, décembre 1992 (1992-12), pages 325-376, XP058191421, ISSN: 0360-0300, DOI: 10.1145/146370.146374**

EP 3 830 789 B1

# Description

## DOMAINE TECHNIQUE DE L'INVENTION

Le domaine technique de l'invention est celui de l'analyse des défauts dans un constituant d'un dispositif, par exemple une cellule photovoltaïque. La présente invention concerne un procédé d'analyse d'au moins un type de défauts parmi une pluralité de types de défauts entre au moins deux échantillons. La présente invention concerne également un dispositif permettant la mise en oeuvre du procédé.

## ARRIERE-PLAN TECHNOLOGIQUE DE L'INVENTION

Lors de la fabrication en série de pièces ou de dispositifs, il est important de pouvoir analyser les défauts desdites pièces ou desdits dispositifs et de comparer la position et le type de défauts entre différents échantillons prélevés sur la ligne de production ou bien encore mesurés lors de la production. Par exemple dans le cas des cellules photovoltaïques, de nombreux facteurs peuvent influencer l'homogénéité des cellules au niveau de leur surface : des contaminants laissés par la manipulation des plaquettes semi-conductrices, des inhomogénéités dans les procédés de fabrication, etc. Par exemple, durant leur fabrication, les cellules photovoltaïques sont soumises à des manipulations qui peuvent conduire à une dégradation de la surface des cellules entrainant une détérioration des performances. De telles détériorations peuvent notamment être identifiées à l'aide d'images de photoluminescence ou d'électroluminescence.

La demande de brevet WO2015/091895 présente un procédé dans lequel une telle caractérisation est proposée. Pour cela, une première étape consiste à acquérir une image de photoluminescence d'un échantillon à examiner. Cette image subit ensuite une étape de nettoyage lors de laquelle les motifs métalliques sont retirés puis une étape de division. A l'issue de l'étape de division, deux images ont été créées : une première image contenant les basses fréquences correspondant aux variations lentes de l'image de départ et une deuxième image contenant les hautes fréquences (et correspondant aux défauts susceptibles d'être introduits lors de la fabrication). Ces deux images sont ensuite utilisées pour produire une métrique des défauts. Ce procédé permet donc d'effectuer un suivi des défauts lors de la fabrication mais présente cependant des inconvénients. Le premier de ces inconvénients provient de la métrique obtenue. Si cette dernière permet de caractériser le niveau de défaut d'un échantillon, aucune information spatiale sur lesdits défauts n'est préservée lors du traitement des images. Il est donc impossible à l'aide de ce procédé d'extraire une information en ce qui concerne la position des défauts. De plus, si l'on souhaite comparer des échantillons entre eux, cette comparaison doit se faire à l'aide d'au moins une des deux images. Or la comparaison entre deux images peut être compliquée du fait du grand nombre de pixels les composant. De plus, une telle comparaison se fait de pixel à pixel ce qui ne permet pas de prendre en compte de légères différences dans la position des défauts d'un échantillon à l'autre. D'autre part, lorsque le nombre d'images à comparer est grand, cette comparaison nécessite une grande puissance de calcul. En outre, tous les échantillons ne sont pas manipulés de manière identique ce qui peut conduire à la présence de défauts définis à une rotation et/ou à une symétrie près.

Une solution similaire est divulguée dans Nos O. et al.: "Quality control method based on photoluminescence imaging for the performance prédiction of c-Si/a-Si:H heterojunction solar cells in industrial production lines",SOLAR ENERGY MATERIALS AND SOLAR CELLS, vol. 144, 2016, pages 210-220.

Il existe donc un besoin d'un procédé qui s'affranchisse des inconvénients ci-dessus. En particulier il existe un besoin d'un procédé qui permette une comparaison des défauts entre plusieurs échantillons tout en conservant une information spatiale sur lesdits défauts et sans que cette comparaison ne soit affectée par les manipulations pseudo aléatoires desdits échantillons.

## RESUME DE L'INVENTION

L'invention offre une solution aux problèmes évoqués précédemment, en permettant de prendre en compte non seulement l'aspect spatial des défauts mais également les différentes manipulations que peuvent subir les échantillons au cours de leur fabrication.

Un premier aspect de l'invention concerne un procédé d'analyse d'au moins un type de défauts parmi une pluralité de types de défauts entre au moins deux échantillons à partir d'une image de chaque échantillon caractéristique d'au moins un type de défauts parmi ladite pluralité de types de défauts. Le procédé selon un premier aspect de l'invention comprend :

- pour chaque échantillon, une étape de création d'au moins une matrice, appelée minicarte, comprenant une pluralité de cases et représentative d'au moins un type de défauts parmi la pluralité de types de défauts et dont la résolution est inférieure à l'image de l'échantillon, chaque case de la minicarte étant associée à une pluralité de pixels de l'image de l'échantillon et ayant un score fonction desdits pixels et représentatif de la quantité d'au moins un type de défauts ;

- une étape de détermination de la distance entre chaque minicarte représentant le ou les mêmes types de défauts parmi la pluralité de types de défauts, la distance entre deux minicartes étant définie comme la distance minimale entre deux minicartes en considérant les transformations suivantes : une rotation et/ou une symétrie, de sorte que chaque distance entre deux minicartes est associée à une transformation.

De plus, l'analyse d'au moins un type de défauts parmi la pluralité de types de défauts entre au moins deux échantillons est effectuée en tenant compte de la transformation associée à la distance entre chaque minicarte représentative du au moins un type de défauts parmi la pluralité de types de défauts.

Grâce à l'invention, il devient possible de comparer des défauts entre plusieurs échantillons tout en conservant une information spatiale sur lesdits défauts et sans que cette comparaison ne soit affectée par les manipulations affectant de manière pseudo aléatoire les échantillons en question. De plus, la résolution des minicartes étant inférieure à la résolution de l'image, l'analyse ne nécessite qu'une durée de calcul courte. Dans la suite, on entend par défauts les défauts de l'échantillon apparaissant sur l'image. Donc, la mention de défauts ou de type de défauts fait référence, non pas au défaut ou au type de défauts lui-même mais à sa manifestation dans l'image. Par exemple, dans le cas d'une image par photoluminescence ou électroluminescence, un défaut pourra être défini comme une zone de l'image dont l'intensité est inférieure à un pourcentage donné de l'intensité maximale de l'image, ou l'intensité maximale locale de l'image. Ce pourcentage seuil pourra par exemple être fixé à 20%, et le maximum local associé à une zone pourra par exemple être pris sur un carré de côté un dixième de la largeur de l'image entourant ladite zone.

Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles.

Dans un mode de réalisation, l'étape de création d'une minicarte comprend :

- une première sous-étape de création d'une grille, la grille ayant une résolution de N × N carreaux où N × N est la résolution de la minicarte à déterminer, le centre de la grille étant aligné sur le centre de l'image et la grille recouvrant entièrement ladite image ;
- une sous-étape de calcul pour chaque carreau de la grille d'un score fonction des pixels de l'image recouverts par ledit carreau, le score de chaque carreau de la grille étant attribuée à la case de la minicarte correspondante.

De manière alternative, l'étape de création d'une minicarte comprend :

- une première sous-étape de création d'une première grille intermédiaire, la première grille intermédiaire ayant une résolution de N × N carreaux où N × N est la résolution de la minicarte, le centre de la première grille intermédiaire étant aligné sur le centre de l'image et la première grille intermédiaire recouvrant entièrement ladite image ;

- une deuxième sous-étape de création d'une deuxième grille intermédiaire, la deuxième grille intermédiaire ayant une résolution de (N - 1) × (N - 1) carreaux, les dimensions des carreaux de la deuxième grille intermédiaire étant égales aux dimensions des carreaux de la première grille intermédiaire, le centre de la deuxième grille étant aligné sur le centre de l'image ;
- une troisième sous-étape de calcul pour chaque carreau de la première grille intermédiaire et de la deuxième grille intermédiaire d'un score fonction des pixels de l'image recouverts par lesdits carreaux ;
- une quatrième sous-étape de calcul du score de chaque case de la minicarte, le score d'une case étant égal à la somme pondérée du score du carreau de la première grille intermédiaire associé à ladite case et de la ou des carreaux de la deuxième grille intermédiaire recouvrant le carreau de la première grille intermédiaire considéré.

Ainsi, il est possible de prendre en compte de légères rotations des défauts entre différents échantillons. Cette méthode de création est particulièrement adaptée lorsque le score est déterminé par une métrique non-linéaire.

Dans un mode de réalisation, le procédé selon un premier aspect de l'invention comprend une étape de détermination d'une quantité de défaut maximum, ladite quantité étant associée à une valeur du score, dite valeur haute de référence.

Ainsi, Il est possible de construire deux visualisations : une visualisation absolue, dans laquelle les valeurs du score supérieures à la valeur haute de référence sont ramenées à la valeur haute de référence (saturation), et une visualisation relative où la minicarte est affichée avec son score minimum ramené à zéro et son score maximum à 100 (cent).

Dans un mode de réalisation, le procédé selon un premier aspect de l'invention comprend, avant l'étape de création d'au moins une minicarte, pour chaque échantillon, une étape d'application d'un masque sur l'image de l'échantillon, l'étape de création d'au moins une minicarte étant réalisée en tenant compte de la présence du masque.

Ainsi, lors de la création des minicartes, il est possible d'exclure certaines parties de l'image relatives à une zone ne correspondant pas à l'échantillon et/ou à une zone de l'échantillon que l'on ne souhaite pas prendre en compte, comme les bords de l'échantillon.

Dans un mode de réalisation, le procédé selon un premier aspect de l'invention comprend, avant l'étape de création d'au moins une minicarte, une étape de filtrage de l'image de l'échantillon.

Cette étape de filtrage permet de créer une minicarte relative à une partie seulement des types de défauts de la pluralité de types de défauts, voire à un unique type de défauts de la pluralité de types de défauts.

Dans un mode de réalisation, le procédé selon un premier aspect de l'invention comprend une étape de superposition des minicartes représentant le ou les mêmes types de défauts parmi la pluralité de types de défauts, ladite superposition se faisant en fonction de la distance séparant lesdites minicartes et en tenant compte de la transformation associée à ladite distance de sorte à obtenir au moins une minicarte résultante.

On entend par minicarte résultante une minicarte obtenue par la superposition d'au moins deux minicartes. Ainsi, il est permis de comparer les minicartes issues de différents échantillons y compris lorsque les échantillons en question ont subi des étapes de manipulation différentes.

Dans un mode de réalisation, le procédé selon un premier aspect de l'invention comprend une étape de superposition des images, ladite superposition se faisant en fonction de la distance séparant les minicartes représentant le ou les mêmes types de défauts parmi la pluralité de types de défauts et associée à chaque image, et en tenant compte de la transformation associée à ladite distance de sorte à obtenir au moins une image résultante.

On entend par image résultante une image obtenue par la superposition d'au moins deux images. Ainsi, il est permis de comparer les images issues de différents échantillons y compris lorsque les échantillons en question ont subi des étapes de manipulation différentes, et ce grâce aux informations apportées par les minicartes et la distance qui les sépare entre elles.

Un deuxième aspect de l'invention concerne un procédé de fabrication de cellules photovoltaïques comprenant au moins une étape d'analyse d'au moins deux échantillons à partir d'une image par photoluminescence ou électroluminescence de chaque échantillon comportant au moins un type de défauts parmi une pluralité de types de défauts à l'aide d'un procédé selon un premier aspect de l'invention.

Un troisième aspect de l'invention concerne un dispositif comprenant les moyens pour mettre en œuvre un procédé selon un premier aspect ou un deuxième aspect de l'invention.

Un quatrième aspect de l'invention concerne un programme d'ordinateur comprenant des instructions qui, lorsque le programme est exécuté par un ordinateur, conduisent celui-ci à mettre en œuvre le procédé selon un premier aspect ou un deuxième aspect de l'invention.

Un cinquième aspect de l'invention concerne un support de données lisible par ordinateur, sur lequel est enregistré le programme d'ordinateur selon un quatrième aspect de l'invention.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

- La figure 1 montre un logigramme d'un procédé selon un premier aspect de l'invention.

- La figure 2 montre une représentation schématique de la construction d'une minicarte dans un mode de réalisation d'un procédé selon un premier aspect de l'invention.

- La figure 3 montre une représentation schématique de deux grilles intermédiaires dans un mode de réalisation d'un procédé selon un premier aspect de l'invention.

- La figure 4 montre une représentation schématique de l'utilisation d'un masque dans un mode de réalisation d'un procédé selon un premier aspect de l'invention

## DESCRIPTION DETAILLEE D'AU MOINS UN MODE DE REALISATION DE L'INVENTION

Sauf précision contraire, un même élément apparaissant sur des figures différentes présente une référence unique.

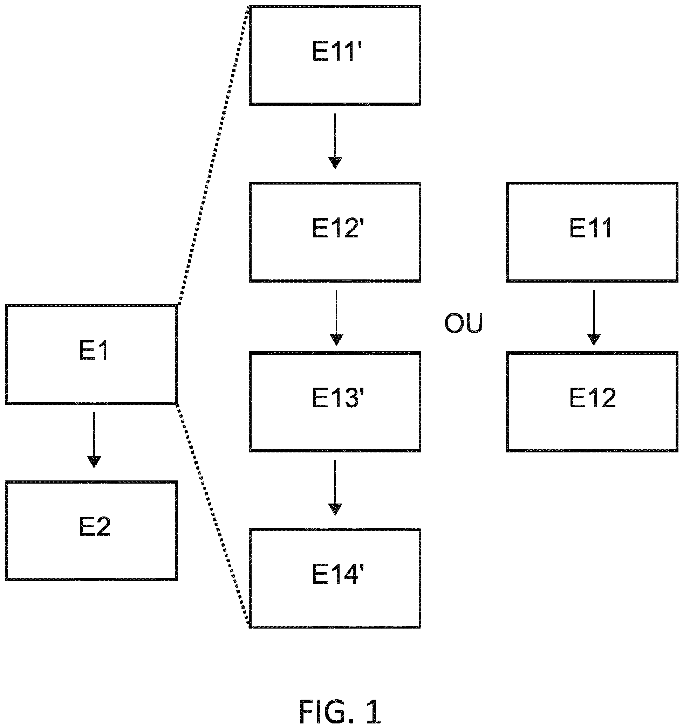

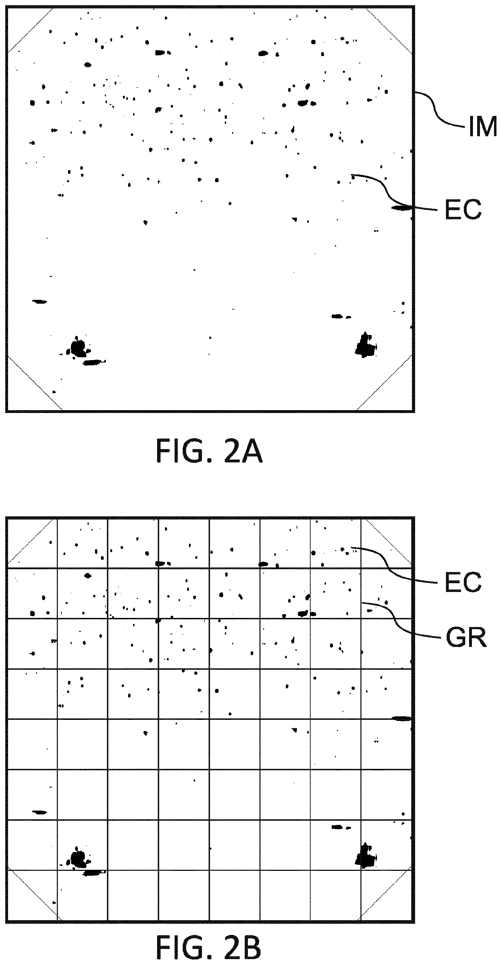

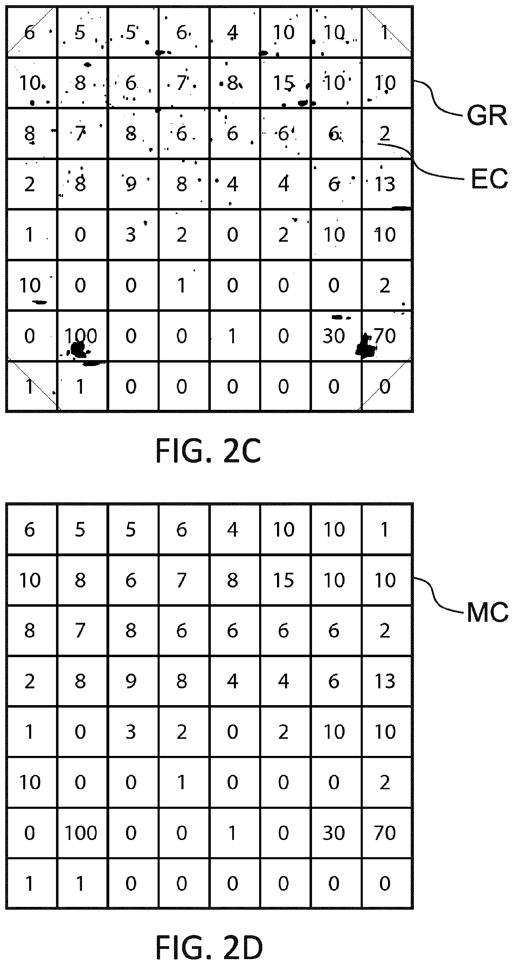

Un mode de réalisation d'un premier aspect de l'invention illustré à la figure 1 concerne un procédé d'analyse d'au moins un type de défauts parmi une pluralité de types de défauts entre au moins deux échantillons EC à partir d'une image IM de chaque échantillon EC caractéristique d'au moins un type de défauts parmi ladite pluralité de types de défauts. Pour rappel, on entend par défauts les défauts de l'échantillon EC apparaissant sur l'image IM. Donc, la mention de défauts fait référence, non pas au défaut lui-même, mais à sa manifestation dans l'image IM. Par exemple, dans le cas d'une image IM par photoluminescence ou électroluminescence, un défaut pourra être défini comme une zone de l'image IM dont l'intensité est inférieure à un pourcentage donné de l'intensité maximale de l'image, ou l'intensité maximale locale de l'image. Ce pourcentage seuil pourra par exemple être fixé à 20%, et le maximum local associé à une zone pourra par exemple être pris sur un carré de côté un dixième de la largeur de l'image entourant ladite zone. De préférence, la géométrie des différents échantillons EC est comparable. On entend par comparable des échantillons EC dont le diamètre (ou la largeur) est identique et dont la forme extérieure est similaire (déviations maximales de moins de 20 % du diamètre ou de la largeur). De préférence, les images IM des différents échantillons EC sont prises dans des conditions comparables. De préférence, lorsque les échantillons EC ont des géométries différentes, l'image IM concerne la zone maximale commune à l'ensemble des échantillons EC. De manière générale, les différences de distance entre le système optique et l'échantillon EC, d'éclairement, de sensibilité du capteur d'image, de distorsion du chemin optique, peuvent être corrigés de sorte à ramener les images IM dans une condition d'acquisition effective équivalente. Les échantillons EC peuvent être des plaquettes (*wafer* en anglais) semi-conductrices et les images IM peuvent être des images IM obtenues par électroluminescence ou photoluminescence. De telles images IM peuvent par exemple être acquises à l'aide d'un procédé tel que décrit dans la demande de brevet WO2015/091895 déjà citée. Ainsi, pour chaque échantillon, une image IM est représentative d'une pluralité de types de défauts (par exemple, des traces de contaminants, des rayures, etc.). L'analyse selon l'invention peut porter sur tout ou partie de ces types de défauts. Par exemple, dans le cas de plaquettes semi-conductrices on pourra s'intéresser à l'ensemble des défauts ou bien alors se concentrer sur un type donné de défauts, par exemple pour identifier un problème de manutention sur une ligne de production. Une telle image IM est illustrée à la figure 2A dans le cas d'une cellule photovoltaïque imagée à l'aide d'une technique de photoluminescence sur laquelle les défauts sont visibles en noir. Comme cela sera détaillé dans la suite, la sélection d'une partie seulement des défauts pourra se faire par l'application d'un filtre sur l'image, ledit filtre étant fonction du type ou des types de défauts auxquels on s'intéresse.

Comme illustré aux figures 2B à 2D, le procédé selon un premier aspect de l'invention comprend, pour chaque échantillon EC, une étape E1 de création d'au moins une minicarte MC comprenant une pluralité de cases et représentative d'au moins un type de défauts parmi la pluralité de types de défauts, et dont la résolution est inférieure à l'image IM de l'échantillon EC. De plus, chaque case de la minicarte MC est associée à une pluralité de pixels de l'image IM de l'échantillon EC et a un score fonction desdits pixels, ledit score étant représentatif de la quantité d'au moins un type de défauts.

La détermination d'une minicarte MC à partir d'une image IM peut se faire de plusieurs manières. Dans un mode de réalisation, la détermination de la minicarte comprend une première sous-étape E11 de création d'une grille GR. Cette grille GR est composée de carreaux et a une résolution de $N \times N$ carreaux où $N \times N$ est la résolution de la minicarte MC que l'on souhaite déterminer. Autrement dit, à chaque carreau de la grille GR est associé une case de la minicarte MC et à chaque case de la minicarte MC est associé un carreau de la grille GR (autrement dit il existe une relation bijective entre les cases de la minicarte MC et les carreaux de la grille GR). De plus, le centre de la grille GR est aligné sur le centre de l'image IM et la grille GR recouvre entièrement ladite image IM. Ainsi, chaque pixel de l'image IM est recouvert par un carreau et chaque carreau recouvre une pluralité de pixels de l'image IM. Le procédé comprend ensuite une deuxième sous-étape E12 de calcul pour chaque carreau de la grille GR d'un score fonction des pixels de l'image IM recouverts par ledit carreau. Par exemple, comme déjà mentionné, si l'image IM est une image IM de photoluminescence, le score associé à un carreau pourra être donné par la valeur moyenne de la luminescence des pixels contenus dans ledit carreau. Bien entendu, afin d'obtenir la minicarte MC, le score de chaque carreau de la grille GR est attribué à la case de la minicarte MC correspondante. Dans ce mode de réalisation, la grille GR est donc identique à la minicarte MC. Cette manière de construire la minicarte MC a pour avantage d'être simple de mise en œuvre. Cependant, si un type de défauts prend la forme d'une ligne horizontale ou verticale sur un premier échantillon EC et la forme d'une ligne légèrement oblique sur un deuxième échantillon EC, cette manière de faire peut accentuer cette légère différence lorsqu'une partie de la ligne oblique passe d'une première ligne (ou colonne) de carreaux à une deuxième ligne (ou colonne) de carreaux dans la grille GR.

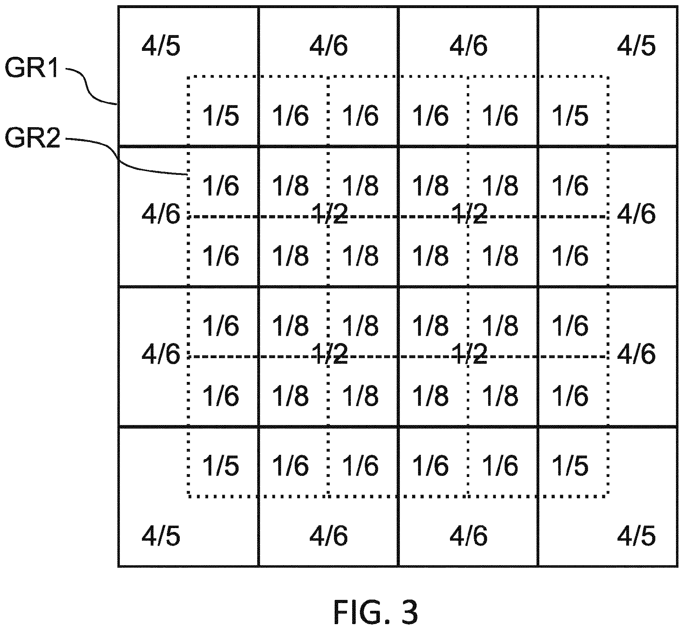

Afin de limiter ce phénomène, il est possible d'utiliser non pas une grille GR mais deux grilles intermédiaires GR1, GR2. Plus particulièrement, dans un mode de réalisation illustré à la figure 3, l'étape de création d'une minicarte MC comprend une première sous-étape E11' de création d'une première grille GR1 intermédiaire, la première grille GR1 intermédiaire (en trait plein sur la figure 3) ayant une résolution de $N \times N$ carreaux où $N \times N$ est la résolution de la minicarte MC, le centre de la première grille GR1 intermédiaire étant aligné sur le centre de l'image IM et la première grille GR1 intermédiaire recouvre entièrement ladite image IM. Ainsi, chaque pixel de l'image IM est recouvert par un carreau de la première grille GR1 intermédiaire et chaque carreau de la première grille GR1 intermédiaire recouvre une pluralité de pixels de l'image IM. Comme dans le cas précédent, à chaque carreau de la première grille GR1 intermédiaire est associée une case de la minicarte MC et à chaque case de la minicarte MC est associé un carreau de la première grille GR1 intermédiaire (autrement dit il existe une relation bijective entre les cases de la minicarte MC et les carreaux de la première grille GR1 intermédiaire). Le procédé comprend ensuite une deuxième sous-étape E12' de création d'une deuxième grille GR2 intermédiaire (en trait pointillé sur la figure 3) avec une résolution de $(N - 1) \times (N - 1)$ carreaux, les dimensions des carreaux de la deuxième grille GR2 intermédiaire étant égales aux dimensions des carreaux de la première grille GR1 intermédiaire, le centre de la deuxième grille GR2 intermédiaire étant aligné sur le centre de l'image IM (et donc sur le centre de la première grille GR1 intermédiaire). Ainsi, chaque carreau de la deuxième grille GR2 intermédiaire recouvre une pluralité de pixels de l'image IM, en revanche tous les pixels de l'image IM ne sont pas recouverts par un carreau de la deuxième grille GR2 intermédiaire. Par construction, chaque carreau de la deuxième grille GR2 intermédiaire recouvre partiellement quatre carreaux de la première grille GR1 intermédiaire. Le procédé comprend ensuite une étape E13' de calcul pour chaque carreau de la première grille GR1 intermédiaire et de la deuxième grille GR2 intermédiaire d'un score fonction des pixels de l'image IM recouverts par lesdits carreaux. Par exemple, comme déjà mentionné, si l'image IM est une image de photoluminescence, le score associé à un carreau sera donné par la valeur moyenne de la luminescence des pixels contenus dans ledit carreau. Enfin, le procédé comprend une étape E14' de calcul du score de chaque case de la minicarte MC, le score d'une case étant égal à la somme pondérée du score du carreau de la première grille GR1 intermédiaire associé à ladite case et de la ou des carreaux de la deuxième grille GR2 intermédiaire recouvrant le carreau de la première grille GR1 intermédiaire considéré. Autrement dit, le score attribué à la case de la minicarte MC associée à un carreau de la première grille GR1 intermédiaire prend en compte le score de ce carreau mais également le ou les scores du ou des carreaux de la deuxième grille GR2 intermédiaire qui recouvrent le carreau de la première grille GR1 intermédiaire considéré. Dans un mode de réalisation, cette prise en compte est faite à l'aide de la somme pondérée suivante

$$S = \alpha(K)s_1 + \sum_{i=1}^{K} \beta(K)s_2^i$$

où S est le score de la case considérée, K est le nombre de carreaux de la deuxième grille GR2 intermédiaire recouvrant le carreau de la première grille GR1 intermédiaire associée à la case de la minicarte MC dont on calcule le score, $\alpha$ est un coefficient de pondération dépendant de K, $s_1$ est le score du carreau de la première grille GR1 intermédiaire associée à la case dont on calcule le score, $\beta$ est un coefficient de pondération dépendant de K et $s_2^i$ est le score du $i^{\text{ème}}$ carreau de la deuxième grille GR2 intermédiaire recouvrant le carreau de la première grille GR1 intermédiaire associée à la case considérée. Dans un mode de réalisation illustré à la figure 3, les coefficients de pondération sont fonctions de la surface de chaque carreau recouvrant la case de la minicarte MC, c'est-à-dire

$$\alpha(K) = 4/(4 + K) \text{ et } \beta(K) = \frac{1}{4+K}.$$

De manière générale, dans la construction d'une fonction d'attribution de score, une calibration initiale est nécessaire. Le score minimum absolu est habituellement choisi comme étant égal à zéro et correspondant à aucun défaut, et le score maximum absolu est défini comme le score d'une région de l'image IM jugé comme extrêmement défectueuse, selon le type de défauts considéré. Cependant, cette définition expérimentale du score maximum absolu amène à des situations où ce score est dépassé lors de l'analyse d'échantillons EC mesurés par la suite. De plus, ce score maximum absolu ne peut pas toujours être relié à des propriétés physiques des défauts, ce qui rend sa vérification difficile (pour rappel, le mot défaut renvoie à la manifestation de ce dernier dans l'image IM de l'échantillon EC et ne nécessite donc pas de connaitre l'origine physique du défaut). Afin de s'affranchir de cette difficulté, il est préférable que le score attribué à chaque case d'une minicarte MC soit un score sans limite supérieure absolue. Le score très élevé de la région jugée très défectueuse issue de l'image IM de calibration sera néanmoins utilisé comme valeur haute de référence pour les visualisations, par exemple fixée à 100. Il est alors possible de construire deux visualisations : une visualisation absolue, dans laquelle les valeurs du score supérieures à la valeur haute de référence sont ramenées à la valeur haute de référence (saturation), et une visualisation relative où la minicarte MC est affichée avec son score minimum ramené à zéro et son score maximum à 100. Autrement dit, dans un mode de réalisation, le procédé selon un premier aspect de l'invention comprend une étape de détermination d'une quantité de défaut maximum, ladite quantité étant associée à une valeur du score, dite valeur haute de référence.

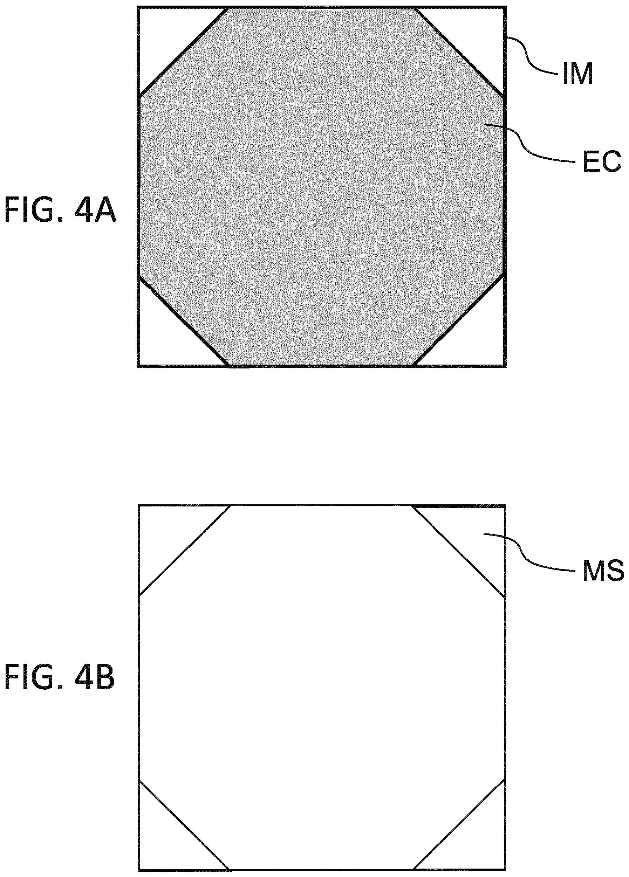

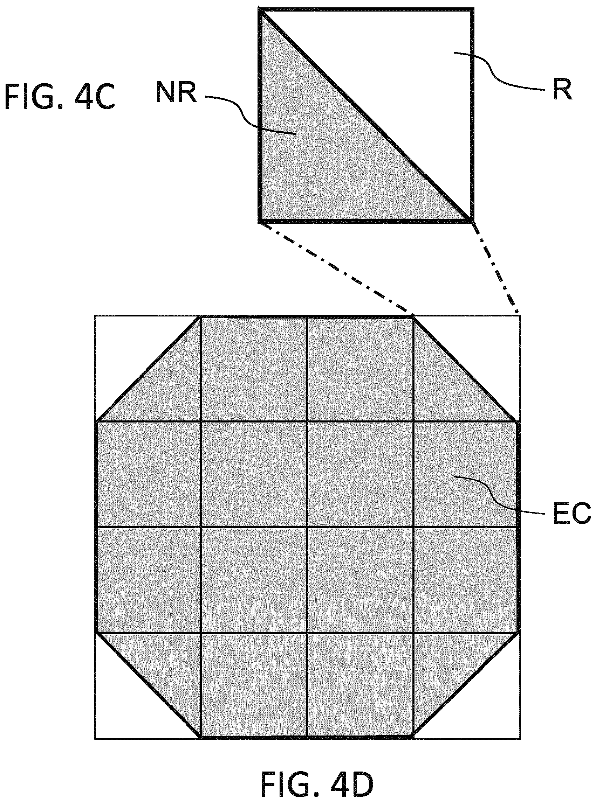

L'image IM d'un échantillon EC n'adopte pas systématiquement le format de l'échantillon EC de sorte qu'une partie de cette image IM n'est pas représentative de l'échantillon EC. Cette situation est par exemple illustrée à la figure 4A où les pixels situés dans les angles de l'image IM ne sont pas représentatifs de l'échantillon EC. De même, il peut être avantageux de ne pas prendre en compte certaines parties de l'image IM, comme par exemples les bords de l'échantillon EC qui constituent des zones particulières. Aussi, dans un mode de réalisation, le procédé comprend, avant l'étape E1 de création d'au moins une minicarte MC, pour chaque échantillon EC, une étape E0 d'application d'un masque MS sur l'image IM de l'échantillon EC. Le masque MS correspondant à l'échantillon EC de la figure 4A est illustré à la figure 4B et comporte quatre zones correspondant chacun à un angle de l'échantillon EC. Une fois ledit masque MS appliqué sur l'image IM de l'échantillon EC, l'étape E1 de création d'au moins une minicarte MC peut être réalisée en tenant compte de la présence du masque MS. Dans un mode de réalisation, le score d'une case d'une minicarte MC est établi en fonction des pixels de l'image IM qu'elle recouvre et qui ne sont pas recouvert par le masque MS, le score ainsi obtenu étant ensuite multiplié par le pourcentage de surface de la case de la minicarte MC non recouverte par le masque MS. Par exemple, dans la figure 4C et la figure 4D, la case supérieure droite est recouverte à 50% par le masque MS, la zone recouverte par ledit masque MS correspondant à la zone ne contenant pas de pixel de l'image IM relatif à l'échantillon EC. Le score associé à cette case de la minicarte MC va être calculé en ne prenant en compte que les pixels de l'image IM dans la zone non recouverte NR et le score ainsi obtenu va être ensuite divisé par le pourcentage de l'aire de la case de la minicarte MC que représente la partie non recouverte NP : ici 50%. Par exemple, si l'image IM est une image IM de photoluminescence, la luminescence moyenne va être calculée à partir des pixels de l'image IM correspondant à la partie de l'échantillon EC non recouverte NR (c'est-à-dire sans prendre en compte les pixels de l'image IM recouvert R par le masque MS) puis la valeur moyenne ainsi obtenue va être multipliée par deux (c'est-à-dire divisée par 50%). On comprendra que le masque MS ainsi décrit peut également recouvrir des zones de l'image IM relatives à l'échantillon EC que l'on ne souhaite pas prendre en compte pour la détermination de la ou des minicartes MC.

Dans un mode de réalisation, la résolution d'une minicarte MC est comprise entre $3 \times 3$ et $48 \times 48$, de préférence égale à $16 \times 16$. Bien entendu, la résolution peut être adaptée à la taille de l'échantillon EC et à la résolution de l'image IM utilisée pour produire la minicarte MC. De manière plus générale, la résolution de la minicarte MC est fixée par les défauts eux-mêmes et plus particulièrement par la taille de ces derniers et par la translation possible de ces défauts entre deux échantillons EC. Par exemple, la résolution de la minicarte MC est choisie de sorte que la taille d'une case de la minicarte MC soit égale à la taille du défaut d'intérêt plus la translation possible dudit défauts d'un échantillon EC à l'autre. Par exemple, la valeur moyenne de ces deux propriétés calculées sur au moins deux échantillons, de préférence une pluralité d'échantillons, est utilisée pour définir la résolution de la minicarte MC.

Lorsque l'on souhaite obtenir une minicarte MC représentative de l'ensemble des défauts, l'image représentative desdits types de défaut peut être utilisée directement. En revanche, si l'image IM est caractéristique d'une pluralité de défauts et que l'on souhaite obtenir une minicarte MC qui ne s'intéresse qu'à un seul type de défauts ou une partie seulement des types de défauts, il est utile d'appliquer un filtre sur l'image avant d'effectuer l'étape E1 de création d'au moins une minicarte MC. Pour cela, dans un mode de réalisation, le procédé comprend, avant l'étape de E1 de création d'au moins une minicarte MC, une étape E0' de filtrage de l'image IM de l'échantillon, ledit filtre étant adapté en fonction du type ou des types de défauts auxquels on s'intéresse.

La première étape E1 qui vient d'être présentée en détail permet de pouvoir effectuer une analyse des défauts en conservant une information spatiale concernant lesdits défauts contrairement au procédé décrit dans la demande de brevet WO2015/091895. Cela permet également de comparer différents échantillons EC entre eux, ce qui n'est pas possible avec l'image IM correspondant auxdits échantillons EC. En effet, dans le cadre d'une image IM, la comparaison pixel à pixel ne donnerait pas de résultat probant du fait notamment que la position d'un défaut, même récurrent d'un échantillon EC à l'autre, peut varier de plusieurs pixels selon les échantillons EC. Il est intéressant pour la suite de noter qu'une minicarte MC peut être vue comme une image IM dans laquelle chaque case est associée à un pixel de l'image IM ou bien encore comme une matrice dans laquelle chaque case est associée à un élément de matrice, la dimension de la matrice étant fonction de la résolution de la minicarte MC. Dans la suite, la représentation matricielle d'une minicarte MC d'un échantillon i sera notée $MC_i$.

Le procédé selon un premier aspect de l'invention comprend également une étape E2 de détermination de la distance entre chaque minicarte MC représentant le ou les mêmes types de défauts parmi la pluralité de types de défauts. Il est important de noter que la distance entre deux minicartes MC n'a de sens que si les deux minicartes MC ont été produites avec les mêmes fonctions d'attribution de score. Aussi, comme cela est précisé, cette étape E2 de calcul de la distance n'est réalisée qu'entre minicartes MC représentant le ou les mêmes types de défauts parmi la pluralité de types de défauts. Comme déjà exposé, la position des défauts peut varier d'un échantillon EC à l'autre. En plus d'une variation légère en translation, cette variation peut également correspondre à une rotation ou une symétrie du fait par exemple d'une ou plusieurs étapes de manipulation de l'échantillon EC. De plus, ces étapes de manipulation peuvent varier d'un échantillon EC à l'autre sur la chaine de production. Pour pouvoir effectuer une comparaison efficace entre échantillon EC, il est donc essentiel de prendre également en compte cet aspect. Dans le procédé selon l'invention, cette prise en compte se fait par la définition de la distance entre deux minicartes MC. Plus particulièrement, la distance entre deux minicartes MC est définie comme la distance minimale entre deux minicartes MC en considérant les transformations suivantes : une rotation et/ou une symétrie. Ainsi, chaque distance entre deux minicartes MC est associée à une transformation. La distance entre deux minicartes MC pourra par exemple être une distance euclidienne. Dans un mode de réalisation, les transformations considérées comprennent une rotation de $n\frac{\pi}{2}$ avec n un entier et/ou une transformation miroir (dans la pratique on peut choisir $n \in [0,3]$). Ainsi, pour mesurer la distance entre deux minicartes MC, on calcule la distance entre les deux minicartes MC en appliquant une transformation sur l'une des deux minicartes MC, et ce pour chaque transformation énumérée ci-dessus, puis on retient la distance la plus courte parmi les distances ainsi déterminées comme étant la distance séparant les deux minicartes MC. Il est donc possible d'associer à chaque distance une transformation ayant permis d'obtenir ladite distance.

Une fois les distances entre minicartes calculées, l'analyse d'au moins un type de défauts parmi la pluralité de types de défauts entre au moins deux échantillons EC est effectuée en tenant compte de la transformation associée à la distance entre chaque minicarte MC représentative du au moins un type de défauts parmi la pluralité de types de défauts.

Dans certains cas, il peut être avantageux de comparer visuellement différents échantillons EC vis-à-vis de tout ou partie de la pluralité de types de défauts. Une telle comparaison peut se faire au moyen de la ou des minicartes MC associées à chaque échantillon EC ou bien encore au moyen de l'image IM associée à chaque échantillon EC. Afin d'effectuer cette comparaison à l'aide d'une minicarte MC, dans un mode de réalisation, le procédé selon un premier aspect de l'invention comprend une étape de superposition des minicartes MC représentant le ou les mêmes types de défauts parmi la pluralité de types de défauts, ladite superposition se faisant en fonction de la distance séparant lesdites minicartes MC et en tenant compte de la transformation associée à ladite distance, de sorte à obtenir au moins une minicarte MC résultante. On appelle minicarte MC résultante une minicarte MC obtenue par la superposition d'au moins deux minicartes MC.

Cette superposition peut par exemple être obtenue par un algorithme de regroupement hiérarchique, par exemple en utilisant une méthode dite Weighted Pair Group Method with Arithmetic Mean (ou WPGMA). Dans cet algorithme, une matrice $\Delta_0$ représentant les distances séparant les minicartes MC considérées est constituée. Par exemple, si l'on suppose cinq minicartes MC chacune associée à un échantillon EC et représentant le ou les mêmes types de défauts parmi la pluralité de types de défauts que les autres minicartes MC, la distance séparant lesdites minicartes MC peut être mise sous la forme matricielle $\Delta_0$ suivante :

$$\Delta_0 = \begin{pmatrix} 0 & 5 & 12 & 23 & 19 \\ 5 & 0 & 42 & 22 & 12 \\ 12 & 42 & 0 & 9 & 43 \\ 23 & 22 & 9 & 0 & 22 \\ 19 & 15 & 43 & 22 & 0 \end{pmatrix}$$

Les deux minicartes MC les plus proches (dont les distances sont en gras dans la matrice) sont ensuite superposées, la superposition ainsi obtenue venant constituer une minicarte MC résultante remplaçant les deux minicartes MC ainsi superposées. Dans l'exemple ci-dessus, la distance la plus faible entre deux minicartes MC est 5 et les deux minicartes MC correspondantes sont superposées pour donner une minicarte MC résultante. D'un point de vue matriciel, superposer une première minicarte $\mathbf{MC_1}$ à une deuxième minicarte $\mathbf{MC_2}$ peut s'écrire sous la forme $\mathbf{MC_{res}} = \frac{1}{2}\mathbf{MC_1} + \frac{1}{2}\mathbf{MC_2}$ où $\mathbf{MC_{res}}$ est la minicarte MC résultant de cette superposition. Les distances séparant cette minicarte MC résultante des autres minicartes MC est ensuite calculée de sorte à obtenir une nouvelle matrice $\Delta_1$ des distances (les distances ayant été recalculées sont en gras et correspondent aux distances séparant la minicarte MC résultante qui vient d'être obtenue des autres minicartes MC) :

$$\Delta_1 = \begin{pmatrix} 0 & 30 & 21 & 17 \\ 30 & 0 & 9 & 43 \\ 21 & 9 & 0 & 22 \\ 17 & 43 & 22 & 0 \end{pmatrix}$$

Dans un mode de réalisation, le processus est répété jusqu'à l'obtention d'une seule minicarte MC. Dans un mode de réalisation, le processus est répété jusqu'à l'obtention d'un nombre prédéfini de minicartes MC. Dans un mode de réalisation, le processus est répété jusqu'à que la distance séparant les deux minicartes MC les plus proches soit supérieure à un seuil prédéterminé. Bien entendu, chaque superposition est effectuée en tenant compte de la transformation associée à la distance séparant les deux minicartes MC à superposer. Autrement dit, si la distance entre une première minicarte MC et une deuxième minicarte MC est associée à une rotation de $\frac{\pi}{2}$ de la deuxième minicarte MC, alors la deuxième minicarte MC subira une rotation de $\frac{\pi}{2}$ avant d'être superposée à la première minicarte MC. De plus, à chaque minicarte MC résultante obtenue à partir de la superposition de deux ou plusieurs minicartes MC est associée un nombre correspondant au nombre de minicartes MC ayant été superposées pour obtenir ladite minicarte MC résultante. Ainsi, un coefficient adapté peut être utilisé lors de la superposition d'une minicarte MC résultante obtenue par superposition d'une pluralité d'autres minicartes et une minicarte MC ne résultant d'aucune superposition. Par exemple, si une première minicarte $\mathbf{MC_{res1}}$ obtenue par la superposition de trois autres minicartes MC est superposée à une deuxième minicarte $\mathbf{MC_2}$ ne résultant d'aucune superposition, la pondération associée à la première minicarte $\mathbf{MC_{res}}$ sera de ¾ et la pondération associée à la deuxième minicarte $\mathbf{MC_2}$ sera de $\frac{1}{4}$ et la nouvelle minicarte $\mathbf{MC_{res2}}$ obtenue par ladite superposition sera donnée par $\mathbf{MC_{res2}} = \frac{3}{4}\mathbf{MC_{res1}} + \frac{1}{4}\mathbf{MC_2}$. De manière plus générale la minicarte $\mathbf{MC_{tot}}$ obtenue par la superposition d'une première minicarte $\mathbf{MC_{part1}}$ correspondant à la superposition de i minicartes MC et d'une deuxième minicarte $\mathbf{MC_{part2}}$ correspondant à la superposition de j minicartes MC est donnée par $\mathbf{MC_{tot}} = \frac{i}{i+j}\mathbf{MC_{part1}} + \frac{j}{i+j}\mathbf{MC_{part2}}$. De plus, la minicarte $\mathbf{MC_{tot}}$ sera associée à un nombre de minicartes MC superposées égal à i + j. A l'issu du procédé, une ou plusieurs minicartes MC résultantes sont ainsi obtenues, ces dernières permettant une comparaison des différents types de défauts. Lorsque plusieurs minicartes MC résultantes sont obtenues (autrement dit qu'un « clustering » des échantillons EC a été réalisé), il est notamment possible d'examiner la distance séparant ces différentes minicartes MC résultantes. Cette distance peut notamment permettre d'évaluer l'hétérogénéité entre les différents échantillons EC. Plus particulièrement, si la distance entre une première minicarte MC et une deuxième minicarte MC est grande, alors l'hétérogénéité est entre les échantillons EC ayant permis d'obtenir la première minicarte MC et les échantillons EC ayant permis d'obtenir la deuxième minicarte MC est également importante. La réalisation de minicarte MC permet donc de regrouper les différents échantillons EC en fonction de l'homogénéité des défauts qui les affectent. Comme cela a déjà été mentionné, il est également possible d'effectuer une comparaison des défauts entre échantillons EC à l'aide de l'image IM associée à chacun de ces échantillons EC. Pour cela, dans un mode de réalisation, le procédé selon un premier aspect de l'invention comprend une étape de superposition des images IM associées à chaque échantillon, ladite superposition se faisant en fonction de la distance séparant les minicartes MC associées auxdites images IM représentant le ou les mêmes types de défauts parmi la pluralité de types de défauts et en tenant compte de la transformation associée à ladite distance, de sorte à obtenir au moins une image IM résultante. On entend par image IM résultante une image obtenue par la superposition d'au moins deux images IM. Il est important de noter que la superposition entre une première image IM et une deuxième image IM se fait à partir d'informations relatives à une première minicarte MC associée à la première image et une deuxième minicarte MC associée à la deuxième image IM, la première et la deuxième minicarte MC étant relatives au même type de défauts ou aux même types de défauts. De plus, lorsque l'on superpose deux images IM, il est nécessaire de prendre en compte le nombre d'images IM superposées pour obtenir lesdites images IM afin d'appliquer les coefficients de pondération adaptée comme cela a déjà été détaillé dans le cas des minicartes MC. Pour cela, comme dans le cas des minicartes, toute image obtenue par la superposition d'autres images est associée à un nombre représentant le nombre d'images IM ayant été nécessaire à son obtention. Autrement dit, l'image **IM$_{tot}$** obtenue par la superposition d'une première image **IM$_{part1}$** correspondant à la superposition de i images IM et d'une deuxième image **IM$_{part2}$** correspondant à la superposition de j images IM est donnée par

$$\mathbf{IM_{tot}} = \frac{i}{i+j}\mathbf{IM_{part1}} + \frac{j}{i+j}\mathbf{IM_{part2}}$$

née par (ici une image est considérée sous sa forme matricielle, chaque pixel de ladite image étant associé à un élément de la matrice). De plus, la minicarte **IM$_{tot}$** sera associée à un nombre d'image IM superposée égal à i + j. La notion de distance associée à une transformation confère au procédé selon l'invention des propriétés que n'aurait pas une comparaison directe des images (si cette dernière était techniquement possible). Notamment, en fonction du ou des types de défaut représentés sur les minicartes MC, la superposition des images IM peut varier. Par exemple, deux images IM peuvent chacune correspondre à une première minicarte MC associée à un premier type de défaut et une deuxième minicarte MC associée à un deuxième type de défaut. De plus, la distance entre la première minicarte MC associée à la première image IM et la première minicarte MC associée à la deuxième image IM peut être associée à une transformation identité tandis que la distance entre la deuxième minicarte MC associée à la première image IM et la deuxième minicarte MC associée à la deuxième image IM peut être associée à une rotation de $\frac{\pi}{2}$ de la deuxième minicarte MC associée à la deuxième image IM. Dans ce cas, si la superposition des deux images IM est effectuée en fonction des premières minicartes MC, ladite superposition se fera sans aucune transformation. En revanche, si la superposition des deux images IM est effectuée en fonction des deuxièmes minicartes MC, ladite superposition se fera après une rotation de $\frac{\pi}{2}$.

Un deuxième aspect de l'invention concerne un procédé de fabrication de cellules photovoltaïques comprenant au moins une étape d'analyse d'au moins un type de défauts parmi une pluralité de types de défauts entre au moins deux échantillons EC à partir d'une image IM par photoluminescence ou électroluminescence de chaque échantillon EC caractéristique d'au moins un type de défauts parmi ladite pluralité de types de défauts à l'aide d'un procédé selon un premier aspect de l'invention. Dans un mode de réalisation, les cellules photovoltaïques sont à base de silicium à homojonction ou hétérojonction. Les échantillons EC peuvent être des plaquettes *as-cut* (c'est-à-dire avant d'entrer dans la ligne de production), des plaquettes prélevées en cours de production ou bien encore les plaquettes une fois le procédé de fabrication terminé.

On notera qu'un procédé selon un premier ou un deuxième aspect de l'invention peut être mis en œuvre dans un cadre de recherches, par exemple pour comprendre les défauts physiques réels de l'échantillon EC ou des échantillons EC. Il peut également être mis en œuvre dans un cadre de contrôle de la qualité des échantillons EC, dans la cadre de la production à proprement parlé ou bien encore dans le cadre d'une calibration lors de la mise en route d'un nouveau procédé de fabrication ou d'une nouvelle ligne de fabrication (« *debugging* » en anglais).

Afin de mettre en œuvre les deux procédés qui viennent d'être détaillés, un troisième aspect de l'invention concerne un dispositif comprenant les moyens pour mettre en œuvre un procédé selon un premier aspect ou un deuxième aspect de l'invention. Dans un mode de réalisation, le dispositif comporte un calculateur (par exemple un processeur, un FPGA ou une carte ASIC) associé à une mémoire. La mémoire peut contenir les instructions nécessaires à l'exécution des différentes étapes dudit procédé ainsi que les données nécessaires à ladite exécution, notamment les images IM ainsi que les minicartes MC obtenues à partir desdites images IM. Dans un mode de réalisation, le dispositif comprend également des moyens pour acquérir des images IM des échantillons à analyser. Dans un mode de réalisation, les moyens d'acquisition comprennent qu'un dispositif d'excitation, par exemple un laser, configuré pour exciter un échantillon de sorte à ce que ce dernier émette des photons par luminescence ainsi qu'un dispositif d'acquisition d'une image IM de luminescence, par exemple une caméra.

**Revendications**

1. Procédé d'analyse d'au moins un type de défauts parmi une pluralité de types de défauts entre au moins deux échantillons (EC) à partir d'une image (IM) de chaque échantillon (EC) caractéristique d'au moins un type de défauts parmi ladite pluralité de types de défauts comprenant :

   - pour chaque échantillon (EC), une étape (E1) de création d'au moins une matrice appelée minicarte (MC) comprenant une pluralité de cases et représentative d'au moins un type de défauts parmi la pluralité de types de défauts dont la résolution est inférieure à l'image (IM) de l'échantillon (EC), chaque case de la minicarte (MC) étant associé à une pluralité de pixels de l'image (IM) de l'échantillon (EC) et ayant un score fonction desdits pixels et représentatif de la quantité d'au moins un type de défauts ;
   - une étape (E2) de détermination de la distance entre chaque minicarte (MC) représentant le ou les mêmes types de défauts parmi la pluralité de types de défauts, la distance entre deux minicartes (MC) étant définie comme la distance minimale entre deux minicartes (MC) en considérant les transformations suivantes : une rotation et/ou une symétrie de sorte que chaque distance entre deux minicartes (MC) est associée à une transformation ;

   l'analyse d'au moins un type de défauts parmi la pluralité de types de défauts entre au moins deux échantillons (EC) étant effectuée en tenant compte de la transformation associée à la distance entre chaque minicarte (MC) représentative d'au moins un type de défauts parmi la pluralité de types de défauts.

2. Procédé selon la revendication 1 **caractérisé en ce que** l'étape (E1) de création d'une minicarte comprend :

   - une première sous-étape (E11) de création d'une grille (GR), la grille (GR) ayant une résolution de N × N carreaux où N × N est la résolution de la minicarte (MC) à déterminer, le centre de la grille (GR) étant aligné sur le centre de l'image (IM) et la grille (GR) recouvrant entièrement ladite image (IM) ;
   - une sous-étape (E12) de calcul pour chaque carreau de la grille (GR) d'un score fonction des pixels de l'image (IM) recouverts par ledit carreau, le score de chaque carreau de la grille (GR) étant attribuée à la case de la minicarte (MC) correspondante.

3. Procédé selon la revendication 1 **caractérisé en ce que** l'étape (E1) de création d'une minicarte comprend :

   - une première sous-étape (E11') de création d'une première grille (GR1) intermédiaire, la première grille (GR1) intermédiaire ayant une résolution de N × N carreaux où N × N est la résolution de la minicarte (MC), le centre de la première grille (GR1) intermédiaire étant aligné sur le centre de l'image (IM) et la première grille (GR1) intermédiaire recouvrant entièrement ladite image (IM) ;
   - une deuxième sous-étape (E12') de création d'une deuxième grille (GR2) intermédiaire, la deuxième grille (GR2) intermédiaire ayant une résolution de (N - 1) × (N - 1) carreaux, les dimensions des carreaux de la deuxième grille (GR2) intermédiaire étant égale aux dimensions des carreaux de la première grille (GR1) intermédiaire, le centre de la deuxième grille (GR2) étant aligné sur le centre de l'image (IM) ;
   - une troisième sous-étape (E13') de calcul pour chaque carreau de la première grille (GR1) intermédiaire et de la deuxième grille (GR2) intermédiaire d'un score fonction des pixels de l'image (IM) recouverts par lesdits carreaux ;
   - une quatrième sous-étape (E14') de calcul du score de chaque case de la minicarte (MC), le score d'une case étant égal à la somme pondérée du score du carreau de la première grille (GR1) intermédiaire associé à ladite case et de la ou des carreaux de la deuxième grille (GR2) intermédiaire recouvrant le carreau de la première grille (GR1) intermédiaire considéré.

4. Procédé selon l'une des revendications précédentes **caractérisé en ce qu'**il comprend une étape de détermination d'une quantité de défaut maximum, ladite quantité étant associée à une valeur du score, dite valeur haute de référence.

5. Procédé selon l'une des revendications précédentes **caractérisé en ce qu'**il comprend, avant l'étape (E1) de création d'au moins une minicarte (MC), pour chaque échantillon (EC), une étape (E0) d'application d'un masque (MS) sur l'image (IM) de l'échantillon (EC), l'étape (E1) de création d'au moins une minicarte (MC) étant réalisée en tenant compte de la présence du masque (MS).

6. Procédé selon l'une des revendications précédentes **caractérisé en ce qu'**il comprend, lorsque l'image (IM) de chaque échantillon (EC) est caractéristique d'une pluralité de types de défauts et avant l'étape de (E1) de création d'au moins une minicarte (MC), une étape (E0') de filtrage de l'image (IM) de l'échantillon.

7. Procédé selon l'une des revendications précédentes **caractérisé en ce qu'**il comprend une étape de superposition des minicartes (MC) représentant le ou les mêmes types de défauts parmi la pluralité de types de défauts, ladite superposition se faisant en fonction de la distance séparant lesdites minicartes (MC), et en tenant compte de la transformation associée à ladite distance, de sorte à obtenir au moins une minicarte (MC) résultante.

8. Procédé selon l'une des revendications précédentes **caractérisé en ce qu'**il comprend une étape de superposition des images (IM), ladite superposition se faisant en fonction de la distance séparant les minicartes (MC) représentant le ou les mêmes types de défauts parmi la pluralité de types de défauts et associée à chaque image (IM), et en tenant compte de la transformation associée à ladite distance, de sorte à obtenir au moins une image (IM) résultante.

9. Procédé de fabrication de cellules photovoltaïques comprenant au moins une étape d'analyse d'au moins deux échantillons (EC) à partir d'une image (IM) par photoluminescence ou électroluminescence de chaque échantillon (EC) comportant au moins un type de défauts parmi une pluralité de types de défauts à l'aide d'un procédé selon l'une des revendications précédentes.

10. Dispositif comprenant les moyens pour mettre en œuvre un procédé selon l'une des revendications précédentes.

11. Programme d'ordinateur comprenant des instructions qui, lorsque le programme est exécuté par un ordinateur, conduisent celui-ci à mettre en œuvre le procédé selon l'une des revendications 1 à 9.

12. Support de données lisible par ordinateur, sur lequel est enregistré le programme d'ordinateur selon la revendication 11.

**Patentansprüche**

1. Analyseverfahren wenigstens eines Fehlertyps aus einer Vielzahl von Fehlertypen aus wenigstens zwei Mustern (EC) ausgehend von einem Bild (IM) jedes Musters (EC), das für wenigstens einen Fehlertyp aus der genannten Vielzahl von Fehlertypen kennzeichnend ist, umfassend:

- für jedes Muster (EC) einen Erstellungsschritt (E1) wenigstens einer Matrix, genannt Minikarte (MC), umfassend eine Vielzahl von Fächern und repräsentativ für wenigsten einen Fehlertyp aus der Vielzahl von Fehlertypen, dessen Auflösung geringer ist als das Bild (IM) des Musters (EC), wobei jedes Fach der Minikarte (MC) einer Vielzahl von Pixeln des Bildes (IM) des Musters (EC) zugeordnet ist und eine Funktionszahl der genannten Pixel aufweist und die Menge wenigstens eines Fehlertyps darstellt;
- einen Bestimmungsschritt (E2) der Entfernung zwischen jeder Minikarte (MC), die den oder die Fehlertyp(en) aus der Vielzahl von Fehlertypen darstellt, wobei die Entfernung zwischen zwei Minikarten (MC) als die Mindestentfernung zwischen zwei Minikarten (MC) unter Berücksichtigung der folgenden Transformationen definiert wird: eine Drehung und/oder eine Symmetrie derart, dass jede Entfernung zwischen zwei Minikarten (MC) einer Transformation zugeordnet ist:
wobei die Analyse wenigstens eines Fehlertyps aus der Vielzahl von Fehlertypen zwischen wenigstens zwei Mustern (EC) unter Berücksichtigung der Transformation durchgeführt wird, die der Entfernung zwischen jeder Minikarte (MC) zugeordnet wird, die wenigstens einen Fehlertyp aus der Vielzahl von Fehlertypen darstellt.

2. Verfahren gemäß Anspruch 1, **dadurch gekennzeichnet, dass** der Erstellungsschritt (E1) einer Minikarte umfasst:

- einen ersten Teil-Erstellungsschritt (E11) eines Gitters (GR), wobei das Gitter (GR) eine Auflösung von N × N Quadraten aufweist, wobei N × N die Auflösung der zu bestimmenden Minikarte (MC) ist, wobei das Zentrum des Gitters (GR) auf dem Zentrum des Bildes (IM) aufgereiht ist und das Gitter (GR) das genannte Bild (IM) vollständig abdeckt;
- einen Berechnungs-Teilschritt (E12) für jedes Quadrat des Gitters (GR) einer Funktionszahl der Pixel des von dem genannten Quadrat abgedeckten Bildes (IM), wobei die Zahl jedes Quadrats des Gitters (GR) dem Fach der entsprechenden Minikarte (MC) zugeordnet ist.

3. Verfahren gemäß Anspruch 1, **dadurch gekennzeichnet, dass** der Erstellungsschritt (E1) einer Minikarte umfasst:

- einen ersten Teil-Erstellungsschritt (E11') eines ersten Zwischen-Gitters (GR1), wobei das erste Zwischen-Gitter (GR1) eine Auflösung von N × N Quadraten aufweist, wobei N × N die Auflösung der Minikarte (MC) ist, wobei das Zentrum des ersten Zwischen-Gitters (GR1) auf dem Zentrum des Bildes (IM) aufgereiht ist und wobei das erste Zwischen-Gitter (GR1) das genannte Bild (IMI vollständig abdeckt;
- einen zweiten Teil-Erstellungsschritt (E12') eines zweiten Zwischen-Gitters (GR2), wobei das zweite Zwischengitter (GR2) eine Auflösung von (N - 1) × (N - 1) Quadraten aufweist, wobei die Abmessungen der Quadrate des zweiten Zwischen-Gitters (GR2) gleich den Abmessungen der Quadrate des ersten Zwischen-Gitters (GR1) sind, wobei das Zentrum des zweiten Gitters (GR2) auf dem Zentrum des Bildes (IM) aufgereiht ist;
- einen dritten Teil-Berechnungsschritt (E13') für jedes Quadrat des ersten Zwischen-Gitters (GR1) und des zweiten Zwischen-Gitters (GR2) einer Funktionszahl der Pixel des Bildes (IM), die von den genannten Quadraten abgedeckt werden;
- einen vierten Teil-Berechnungsschritt (E14') der Zahl jedes Fachs der Minikarte (MC), wobei die Zahl eines Fachs gleich der gewichteten Summe der Zahl des Quadrats des ersten Zwischen-Gitters (GR1), das dem genannten Fach zugeordnet ist, und des Quadrats oder der Quadrate des zweiten Zwischen-Gitters (GR2), das das Quadrat des ersten betrachteten Zwischen-Gitters (GR1) abdeckt, ist.

4. Verfahren gemäß einem der voranstehenden Ansprüche, **dadurch gekennzeichnet, dass** es einen Bestimmungsschritt einer maximalen Fehlermenge umfasst, wobei die genannte Menge einem Wert der Zahl, bezeichnet als hoher Referenzwert, zugeordnet wird.

5. Verfahren gemäß einem der voranstehenden Ansprüche, **dadurch gekennzeichnet, dass** es vor dem Erstellungsschritt (E1) wenigstens einer Minikarte (MC) für jedes Muster (EC) einen Anwendungsschritt (E0) einer Maske (MS) auf das Bild (IM) des Musters (EC) umfasst, wobei der Erstellungsschritt (E1) wenigstens einer Minikarte (MC) unter Berücksichtigung des Vorhandenseins der Maske (MS) realisiert wird.

6. Verfahren gemäß einem der voranstehenden Ansprüche, **dadurch gekennzeichnet, dass** es einen Filterschritt (E0') des Bildes (IM) des Musters umfasst, wenn das Bild (IM) jedes Musters (EC) durch eine Vielzahl von Fehlertypen gekennzeichnet ist, und vor dem Erstellungsschritt (E1) wenigstens einer Minikarte (E0').

7. Verfahren gemäß einem der voranstehenden Ansprüche, **dadurch gekennzeichnet, dass** es einen Überlagerungsschritt der Minikarten (MC) umfasst, der denselben oder dieselben Fehlertyp(en) aus der Vielzahl von Fehlertypen darstellt, wobei die genannte Überlagerung in Abhängigkeit von der Entfernung, die die genannten Minikarten (MC) trennt, und unter Berücksichtigung der Transformation, die der genannten Entfernung zugeordnet ist, derart erfolgt, dass wenigstens eine resultierende Minikarte (MC) erhalten wird.

8. Verfahren gemäß einem der voranstehenden Ansprüche, **dadurch gekennzeichnet, dass** es einen Überlagerungsschritt der Bilder (IM) umfasst, wobei die genannte Überlagerung in Abhängigkeit von der Entfernung, die die Minikarten (MC) trennt, die denselben Fehlertyp oder dieselben Fehlertypen aus der Vielzahl von Fehler darstellt und jedem Bild (IM) zugeordnet ist, und unter Berücksichtigung der Transformation, die jeder Entfernung zugeordnet ist, derart erfolgt, dass wenigstens ein resultierendes Bild (IM) erhalten wird.

9. Herstellungsverfahren von photovoltaischen Zellen, umfassend wenigstens einen Analyseschritte von wenigstens zwei Mustern (EC) ausgehend von einem Bild (IM) per Photolumineszenz oder Elektrolumineszenz jedes Musters (EC), umfassend wenigstens einen Fehlertyp aus einer Vielzahl von Fehlertypen mithilfe eines Verfahren gemäß einem der voranstehenden Ansprüche.

10. Vorrichtung, umfassend die Mittel zum Umsetzen eines Verfahrens gemäß einem der voranstehenden Ansprüche.

11. Computerprogramm, umfassend Anweisungen, die, wenn das Programm durch einen Computer ausgeführt wird, diesen dazu veranlassen, das Verfahren gemäß einem der Ansprüche 1 bis 9 umzusetzen.

12. Per Computer lesbarer Datenträger, auf dem das Computerprogramm gemäß Anspruch 11 gespeichert ist.

**Claims**

1. Method of analysing defects of at least one type from among a plurality of types of defects between at least two samples (EC) on the basis of an image (IM) of each sample (EC) characteristic of at least one type of defects from among said plurality of types of defects comprising:

- for each sample (EC), a step (E1) of creating at least one matrix called a minimap (MC) comprising a plurality of boxes and representative of at least one type of defects from among the plurality of types of defects of which the resolution is less than the image (IM) of the sample (EC), each box of the minimap (MC) being associated with a plurality of pixels of the image (IM) of the sample (EC) and having a score dependent on said pixels and representative of the quantity of at least one type of defects;

- a step (E2) of determining the distance between each minimap (MC) representing the same type or types of defects from among the plurality of types of defects, the distance between two minimaps (MC) being defined as the minimum distance between two minimaps (MC) by considering the following transformations: a rotation and/or a symmetry so that each distance between two minimaps (MC) is associated with a transformation;

the analysis of at least one type of defects from among the plurality of types of defects between at least two samples (EC) being performed by taking account of the transformation associated with the distance between each minimap (MC) representative of the at least one type of defects from among the plurality of types of defects.

2. Method according to claim 1 **characterised in that** the step (E1) of creating a minimap comprises:

   - a first substep (E11) of creating a grid (GR), the grid (GR) having a resolution of N × N squares where N × N is the resolution of the minimap (MC) to be determined, the centre of the grid (GR) being aligned on the centre of the image (IM) and the grid (GR) entirely covering said image (IM);
   - a substep (E12) of calculating for each square of the grid (GR) a score according to the pixels of the image (IM) covered by said square, the score of each square of the grid (GR) being attributed to the box of the corresponding minimap (MC).

3. Method according to claim 1 **characterised in that** the step (E1) of creating a minimap comprises:

   - a first substep (E11') of creating a first intermediate grid (GR1), the first intermediate grid (GR1) having a resolution of N × N squares where N × N is the resolution of the minimap (MC), the centre of the first intermediate grid (GR1) being aligned on the centre of the image (IM) and the first intermediate grid (GR1) entirely covering said image (IM);

   - a second substep (E12') of creating a second intermediate grid (GR2), the second intermediate grid (GR2) having a resolution of (N - 1) × (N - 1) squares, the dimensions of the squares of the second intermediate grid (GR2) being equal to the dimensions of the squares of the first intermediate grid (GR1), the centre of the second grid (GR2) being aligned on the centre of the image (IM);
   - a third substep (E13') of calculating for each square of the first intermediate grid (GR1) and of the second intermediate grid (GR2) a score according to the pixels of the image (IM) covered by said squares;
   - a fourth substep (E14') of calculating the score of each box of the minimap (MC), with the score of one box being equal to the weighted sum of the score of the square of the first intermediate grid (GR1) associated with said box and of the square or squares of the second intermediate grid (GR2) covering the square of the first intermediate grid (GR1) considered.

4. Method according to one of the preceding claims **characterised in that** it comprises a step of determining a maximum quantity of defects, said quantity being associated with a value of the score, referred to as high reference value.

5. Method according to one of the preceding claims **characterised in that** it comprises, before the step (E1) of creating at least one minimap (MC), for each sample (EC), a step (E0) of applying a mask (MS) on the image (IM) of the sample (EC), the step (E1) of creating at least one minimap (MC) being carried out by taking account of the presence of the mask (MS).

6. Method according to one of the preceding claims **characterised in that** it comprises, when the image (IM) of each sample (EC) is characteristic of a plurality of types of defects and before the step (E1) of creating at least one minimap (MC), a step (E0') of filtering the image (IM) of the sample.

7. Method according to one of the preceding claims **characterised in that** it comprises a step of superpositioning minimaps (MC) representing the same type or types of defects from among the plurality of types of defects, said superpositioning being done according to the distance that separates said minimaps (MC), and by taking account of the transformation associated with said distance, in such a way as to obtain at least one resulting minimap (MC).

8. Method according to one of the preceding claims **characterised in that** it comprises a step of superpositioning images (IM), said superpositioning being done according to the distance that separates the minimaps (MC) representing the same type or types of defects from among the plurality of types of defects and associated with each image (IM), and by taking account of the transformation associated with said distance, in such a way as to obtain at least one resulting image (IM).

9. Method for manufacturing photovoltaic cells comprising at least one step of analysing at least two samples (EC) on the basis of an image (IM) by photoluminescence or electroluminescence of each sample (EC) comprising at least one type of defects from among a plurality of types of defects using a method according to one of the preceding claims.

10. Device comprising means for implementing a method according to one of the preceding claims.

11. Computer program comprising instructions that, when the program is executed by a computer, lead the latter to implement the method according to one of claims 1 to 9.

12. Data support that can be read by a computer, on which the computer program according to claim 11 is recorded.

FIG. 1

FIG. 2A

FIG. 2B

| | | | | | | | |
|---|---|---|---|---|---|---|---|
| 6 | 5 | 5 | 6 | 4 | 10 | 10 | 1 |
| 10 | 8 | 6 | 7 | 8 | 15 | 10 | 10 |
| 8 | 7 | 8 | 6 | 6 | 6 | 6 | 2 |
| 2 | 8 | 9 | 8 | 4 | 4 | 6 | 13 |
| 1 | 0 | 3 | 2 | 0 | 2 | 10 | 10 |
| 10 | 0 | 0 | 1 | 0 | 0 | 0 | 2 |
| 0 | 100 | 0 | 0 | 1 | 0 | 30 | 70 |
| 1 | 1 | 0 | 0 | 0 | 0 | 0 | 0 |

GR

EC

**FIG. 2C**

| | | | | | | | |
|---|---|---|---|---|---|---|---|
| 6 | 5 | 5 | 6 | 4 | 10 | 10 | 1 |
| 10 | 8 | 6 | 7 | 8 | 15 | 10 | 10 |
| 8 | 7 | 8 | 6 | 6 | 6 | 6 | 2 |
| 2 | 8 | 9 | 8 | 4 | 4 | 6 | 13 |
| 1 | 0 | 3 | 2 | 0 | 2 | 10 | 10 |
| 10 | 0 | 0 | 1 | 0 | 0 | 0 | 2 |
| 0 | 100 | 0 | 0 | 1 | 0 | 30 | 70 |
| 1 | 1 | 0 | 0 | 0 | 0 | 0 | 0 |

MC

**FIG. 2D**

| | | | | | | |
|---|---|---|---|---|---|---|
| 4/5 | | 4/6 | | 4/6 | | 4/5 |
| | 1/5 | 1/6 | 1/6 | 1/6 | 1/6 | 1/5 |
| 4/6 | 1/6 | 1/8 | 1/8 | 1/8 | 1/8 | 1/6 | 4/6 |
| | 1/6 | 1/8 | 1/8 | 1/8 | 1/8 | 1/6 |
| 4/6 | 1/6 | 1/8 | 1/8 | 1/8 | 1/8 | 1/6 | 4/6 |
| | 1/6 | 1/8 | 1/8 | 1/8 | 1/8 | 1/6 |
| | 1/5 | 1/6 | 1/6 | 1/6 | 1/6 | 1/5 |
| 4/5 | | 4/6 | | 4/6 | | 4/5 |

GR1

GR2

FIG. 3

FIG. 4A

IM

EC

FIG. 4B

MS

FIG. 4C

NR

R

EC

FIG. 4D

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2015091895 A

**Littérature non-brevet citée dans la description**

- **NOS O. et al.** Quality control method based on photoluminescence imaging for the performance prédiction of c-Si/a-Si:H heterojunction solar cells in industrial production lines. *SOLAR ENERGY MATERIALS AND SOLAR CELLS,* 2016, vol. 144, 210-220